# EUROPEAN PATENT APPLICATION

(11) **EP 4 462 489 A1**
(43) Date of publication of application: **13.11.2024**
(21) Application number: 23210295.4
(22) Date of filing: 16.11.2023
(51) Int. Cl.: H01L 31/0745, H01L 31/0747, H01L 31/0216, H01L 31/18

(54) **HYBRID SOLAR BATTERY AND PHOTOVOLTAIC MODULE**

(30) Priority: 10.05.2023 CN 202310526094
(71) Applicant: Trina Solar Co., Ltd, Changzhou, Jiangsu 213031 (CN)
(72) Inventor: YANG, Guangtao, Changzhou, 213031 (CN); CHEN, Daming, Changzhou, 213031 (CN); CHEN, Yifeng, Changzhou, 213031 (CN)
(74) Representative: Nederlandsch Octrooibureau

(57) **Abstract**

The present application provides a hybrid solar battery, composing of: a first surface and a second surface opposing to each other, and the hybrid solar battery is further composed of a silicon substrate; a tunneling layer located between the silicon substrate and the first surface; and an intrinsic amorphous silicon layer is located between the silicon substrate and the second surface. The hybrid solar battery and photovoltaic module proposed in this application can reduce the parasitic absorption of the film layer the production cost on the basis of improving the conversion efficiency of the battery.

## Description

### Technical Field

This application mainly relates to the field of photovoltaic technology, and in particular to a hybrid solar battery and a photovoltaic module.

### Background

With the development of photovoltaic technology, different types of solar batteries are gradually favored by researchers and the market, so various new crystalline silicon structure batteries and technologies emerge in an endless stream. Among the many battery types, each battery type has its own advantages and disadvantages. Under such a premise, the combination of different types of batteries can make better use of the advantages of the battery, but at the same time, it is also necessary to redesign the structure of each film layer, so that the battery can be continuously optimized of conversion efficiency on the basis of realizing the combination of multiple types of batteries.

### Summary

The technical problem to be solved in this application is to provide a hybrid solar battery and photovoltaic module, which can reduce the parasitic absorption of the film layer and the production cost on the basis of improving the conversion efficiency of the battery.

In order to solve the above technical problems, the present application provides a hybrid solar battery, comprising a first surface and a second surface opposing to each other, the hybrid solar battery comprises a silicon substrate; a tunneling layer located between the silicon substrate and the first surface; and an intrinsic amorphous silicon layer located between the silicon substrate and the second surface.

In one embodiment of the present invention, the first surface is the light-facing surface of the hybrid solar battery, and the second surface is the backlight surface of the hybrid solar battery.

In one embodiment of the present invention, the thickness of the tunneling layer is not more than 3 nanometers, and the tunneling layer is composed of silicon oxide, silicon oxynitride or aluminum oxide.

In one embodiment of the present invention, the hybrid solar battery further comprises a first doped layer located between the tunneling layer and the first surface, wherein the thickness of the first doped layer ranges from 20 to 600 nanometers.

In one embodiment of the present invention, the first doped layer comprises doped polysilicon, and the doped polysilicon contains at least one element among oxygen, carbon, and nitrogen.

In one embodiment of the present invention, the hybrid solar battery further comprises a diffusion surface region located on the silicon substrate and below the tunneling layer, wherein the doping type of the diffusion surface region is the same as that of the first doped layer, and the doping concentration of the diffusion surface region is less than that of the first doped layer.

In one embodiment of the present invention, the hybrid solar battery further comprises a first conductive layer located between the first doped layer and the first surface, wherein the thickness of the first conductive layer ranges from 10 to 200 nanometers.

In one embodiment of the present invention, the hybrid solar battery further comprises a dielectric layer, the dielectric layer is located on the outermost layer close to the first surface.

In one embodiment of the present invention, the dielectric layer is silicon nitride, silicon oxide or silicon oxynitride, and the thickness of the dielectric layer ranges from 10 to 200 nanometers.

In one embodiment of the present invention, the intrinsic amorphous silicon layer contains at least one element among oxygen, carbon and nitrogen, and the thickness of the intrinsic amorphous silicon layer ranges from 3-15 nanometers.

In one embodiment of the present invention, further comprising a second doped layer located between the intrinsic amorphous silicon layer and the second surface, wherein the thickness of the second doped layer ranges from 3 to 60 nanometers.

In one embodiment of the present invention, the second doped layer comprises a doped amorphous silicon or microcrystalline silicon film, and the second doped layer contains at least one element of oxygen, carbon, and nitrogen, wherein the doping type of the second doped layer is opposite to that of the silicon substrate.

In one embodiment of the present invention, the doping type of the silicon substrate is N-type doping.

In one embodiment of the present invention, the hybrid solar battery further comprises a second conductive layer, located between the second conductive layer and the second surface, wherein the thickness of the second conductive layer ranges from 10-200 nanometers.

In one embodiment of the present invention, the first surface is the backlight surface of the hybrid solar battery, and the second surface is the light-facing surface of the hybrid solar battery, wherein the hybrid solar battery further comprises a first doped layer located between the tunneling layer and the first surface, the thickness of the first doped layer is 20-600 nanometers.

In one embodiment of the present invention, the thickness of the tunneling layer is not more than 3 nanometers, and the tunneling layer is composed of silicon oxide, silicon oxynitride or aluminum oxide.

In one embodiment of the present invention, the intrinsic amorphous silicon layer contains at least one element among oxygen, carbon and nitrogen, and the thickness of the intrinsic amorphous silicon layer is 3-15 nanometers.

Another aspect of the present invention also provides a photovoltaic module, comprising a plurality of hybrid solar batteries according to any one of the above embodiment and the hybrid solar batteries are connected in series and/or in parallel.

Compared with the prior art, the present application has the following advantages: the present application combines a passivated contact solar battery structure containing a tunneling oxide layer with a heterojunction battery to obtain a hybrid solar battery, which has higher conversion efficiency; at the same time, by optimizing the arrangement and size of the film layer, the parasitic absorption of the film layer can be effectively reduced, the spectral response of the battery can be improved, and the cost of the battery can be reduced.

### Brief Description of the Drawings

The drawings are included to provide a further understanding of the present application, and they are included and constitute a part of the present application, the drawings show the embodiments of the present application, and serving to explain the principles of the present application together with the description. In the drawings:
Fig. 1 is a schematic structural view of a hybrid solar battery in an embodiment of the present application;
Fig. 2 is a schematic structural view of a hybrid solar battery in another embodiment of the present application;
Fig. 3 is a schematic structural view of a hybrid solar battery in another embodiment of the present application; and
Fig. 4 is a schematic structural view of a hybrid solar battery in another embodiment of the present application.

### Preferred Embodiment of the Present Invention

In order to illustrate the technical solutions in the embodiments of the present application more clearly, the drawings that need to be used in the description of the embodiments will be briefly introduced below. Obviously, the drawings in the following description are only some embodiments of the present application, and for those skilled in the art, other drawings can also be obtained based on these drawings without creative effort.

As indicated in this application and claims, the terms "a", "an", "a kind of" and/or "the" do not specifically refer to the singular and may include the plural unless the context clearly indicates an exception. Generally speaking, the terms "comprising" and "including" only suggest the inclusion of clearly identified steps and elements, and these steps and elements do not constitute an exclusive list, and the method or device may also contain other steps or elements.

The relative arrangements of components and steps, numerical expressions and numerical values set forth in these embodiments do not limit the scope of the present application unless specifically stated otherwise. At the same time, it should be understood that, for the convenience of description, the sizes of the various parts shown in the drawings are not drawn according to the actual proportional relationship. Techniques, methods and devices known to those of ordinary skill in the relevant art may not be discussed in detail, but where appropriate, such techniques, methods and devices should be considered part of the authorized specification. In all embodiments shown and discussed herein, any specific values should be construed as illustrative only, and not as limiting. Therefore, other examples of the exemplary embodiment may have different values. It should be noted that like numerals and letters denote like items in the following figures, therefore, once an item is defined in one figure, it does not require further discussion in subsequent drawings.

In the description of the present application, it should be understood that orientation words such as "front, back, up, down, left, right", " landscape, portrait, vertical, horizontal" and "top, bottom" etc. indicating the orientation or positional relationship is generally based on the orientation or positional relationship shown in the drawings, only for the convenience of describing the application and simplifying the description, in the absence of a contrary statement, these orientation words do not indicate or imply that the device or element referred to must have a specific orientation or be constructed and operated in a specific orientation, and therefore cannot be construed as limiting the scope of protection of this application; the orientation words "inside and outside" refer to inside and outside relative to the outline of each part itself.

For the convenience of description, spatially relative terms may be used here, such as "on ...", "over ...", "on the upper surface of ...", "above", etc., to describe the spatial positional relationship between one device or feature and other devices or features. It will be understood that, in addition to the orientation depicted in the drawings, the spatially relative terms are intended to encompass different orientations of the device in use or operation. For example, if the device in the drawings is turned over, devices described as "on other devices or configurations " or "above other devices or configurations" would then be oriented "beneath other devices or configurations " or "under other devices or configurations ". Thus, the exemplary term "above" can encompass both an orientation of "above" and "beneath". The device may be otherwise oriented (rotated 90 degrees or at other orientations), and making a corresponding explanation for the space relative description used here.

In addition, it should be noted that the use of words such as "first" and "second" to define components is only for the convenience of distinguishing corresponding components, unless otherwise stated, the above words have no special meanings, and therefore cannot be construed as limiting the protection scope of the present application. In addition, although the terms used in this application are selected from well-known and commonly used terms, some terms mentioned in the specification of this application may be selected by the applicant according to his or her judgment, and their detailed meanings are listed in this article described in the relevant section of the description. Furthermore, it is required that this application be understood not only by the actual terms used, but also by the meaning implied by each term.

It will be understood that when an element is referred to as being "on," "connected to," "coupled to" or "in contacting with" another element, it can be directly on, connected to, coupled to, or in contact with the other element, or there may be an intervening component. In contrast, when an element is referred to as being "directly on," "directly connected to," "directly coupled to" or "directly in contacting with" another element, there are no intervening elements present. Likewise, when a first component is referred to as being "electrically contacting" or "electrically coupled to" a second component, there exists an electrical path between the first component and the second component that allows electrical current to flow. This electrical path may include capacitors, coupled inductors, and/or other components that allow current to flow, even without direct contact between conductive components.

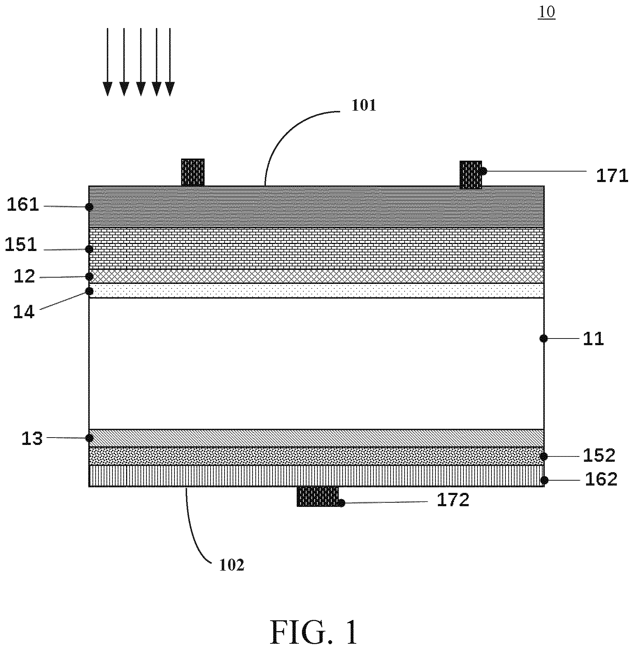

An embodiment of the present application proposes a hybrid solar battery 10 with reference to Fig. 1, which can reduce the parasitic absorption of the film layer and production cost on the basis of improving the conversion efficiency of the battery.

According to Fig. 1, the hybrid solar battery 10 has first surface 101 and second surface 102 opposing to each other. Specifically, in this embodiment, the first surface 101 is also the light-facing surface of the hybrid solar battery 10, and the second surface 102 is also the backlight surface of the hybrid solar battery 10.

Specifically, the hybrid solar battery 10 mainly comprises a silicon substrate 11, a tunneling layer 12 and an intrinsic amorphous silicon layer 13. Wherein, the tunneling layer 12 is located between the silicon substrate 11 and the first surface 101, and the intrinsic amorphous silicon layer 13 is located between the silicon substrate 11 and the second surface 102. Exemplarily, the silicon substrate 11 can be N-type or P-type; when the silicon substrate 11 is N-type doped, phosphorus or arsenic doping elements can be applied, and when the silicon substrate 11 is P-type doped, boron or gallium can be selected as the doping element.

In various embodiments of the present application including Fig. 1, the thickness of the tunneling layer 12 is not more than 3 nanometers, and preferably, the range can be further narrowed to 1.5-2.3 nanometers. The material of the tunneling layer 12 can be selected from silicon oxide, silicon oxynitride or aluminum oxide. On the other hand, in multiple embodiments of the present application, the intrinsic amorphous silicon layer 13 contains at least one element among oxygen, carbon, and nitrogen, and plays a passivation role in the hybrid solar battery 10, and in different embodiments of the application, the thickness range of the intrinsic amorphous silicon layer 13 is preferably 3-15 nanometers.

Further, the hybrid solar battery 10 shown in Fig. 1 further comprises a first doped layer 151 located between the tunneling layer 12 and the first surface 101. Preferably, the thickness of the first doped layer 151 ranges from 20 to 600 nanometers, and in this range, the thickness is preferably controlled between 3 to 30 nanometers; in some cases, the range can be further narrowed to 10-20 nanometers. Exemplarily, the first doped layer 151 includes doped polysilicon, and the doped polysilicon contains at least one element among oxygen, carbon and nitrogen. In the embodiment shown in Fig. 1, the hybrid solar battery 10 further comprises a diffusion surface region 14 located on the silicon substrate 11, the diffusion surface region 14 is below the tunneling layer 12. Wherein, the doping type of the diffusion surface region 14 is the same as that of the first doped layer 151, and the doping concentration of the diffusion surface region 14 is smaller than the doping concentration of the first doped layer 151; meanwhile, in this embodiment, the doping concentration of the diffusion surface region 14 tends to decrease gradually toward the silicon substrate 11. Exemplarily, in different embodiments of the present application, the doping type of the first doped layer 151 may be n-type doping or p-type doping, wherein the n-type doping method is preferred.

In addition, the hybrid solar battery 10 further comprises a first conductive layer 161 located between the first doped layer 151 and the first surface 101; at this time, according to the placement sequence shown in Fig. 1, the upper surface of the first conductive layer 161 can be understood to be exactly the first surface 101 of the hybrid solar battery 10. Wherein, the thickness range of the first conductive layer 161 is 10-200 nanometers. There is also a first electrode 171 on the first conductive layer 161, which may specifically be realized as a metal grid line, for example, a copper-containing grid line. Exemplarily, the first conductive layer 161 may use transparent conductive materials such as ZnO, InO, SnO, etc., and these materials may be doped with at least one element among elements such as Ga, Sn, Mo, Ce, F, W, and Al. It should be noted that, on this basis, in different embodiments of the present application, a dielectric (anti-reflection) layer can be added on the basis of the first conductive layer 161, or the first conductive layer 161 can be directly replaced with dielectric (anti-reflection) layer, this part will be further explained below in conjunction with other drawings.

From the above description with reference to Fig. 1, it can be seen that on the side of the silicon substrate 11 close to the first surface 101 (the light-facing surface), there is a film layer structure mainly composed of the tunneling layer 12, it should be emphasized that the first doped layer 151 adopts a relatively thin thickness, so that the hybrid solar battery 10 can be designed as a thin film layer on the side close to the light-facing surface, thereby reducing the parasitic absorption of the film layer, thereby effectively minimizing the optical loss and improving the spectral response of the battery, achieving better battery efficiency. At the same time, the structural design of the thin film layer can also reduce the manufacturing cost of the battery.

On the basis of the above description, the following description will focus on the other part of the hybrid solar battery 10, that is, the layer structure between the silicon substrate 11 and the second surface 102. Specifically, in this embodiment, the hybrid solar battery 10 further comprises a second doped layer 152 located between the intrinsic amorphous silicon layer 13 and the second surface 102. Wherein, the thickness of the second doped layer 152 ranges from 3 to 60 nanometers, and preferably, it can be set to 15 to 25 nanometers.

Exemplarily, the second doped layer 152 comprises doped amorphous silicon or microcrystalline silicon film, which contains at least one element among oxygen, carbon and nitrogen. It should be noted that, in the multiple embodiments of the present application including Fig. 1, the doping type of the second doped layer 152 is opposite to that of the silicon substrate 11 (at the same time, the doping type of the second doped layer 152 is opposite to that of the first doped layer 151). Preferably, the doping type of the silicon substrate 11 is N-type doping, and the doping type of the second doped layer 152 is P-type doping. Such a configuration can further improve the efficiency of the hybrid solar battery 10.

On this basis, the hybrid solar battery further comprises a second conductive layer 162, located between the second doped layer 152 and the second surface 102, at this time, the lower surface of the second conductive layer 162 can also be understood as the second surface 102. Specifically, the thickness of the second conductive layer 162 may be selected within a range of 10-200 nanometers. There is also a second electrode 172 on the second conductive layer 162, which may specifically be realized as a metal grid line, for example, a copper-containing grid line. Exemplarily, the second conductive layer 162 may use transparent conductive materials such as ZnO, InO, SnO, etc., and these materials may be doped with at least one element among elements such as Ga, Sn, Mo, Ce, F, W, and Al.

It can be seen from the above description that the side of the hybrid solar battery 10 close to the second surface 102 (the backlight surface) has a heterojunction battery structure mainly composed of the intrinsic amorphous silicon layer 13. By cooperating with the aforementioned TOPCon battery structure mainly based on the tunneling layer 12, the hybrid solar battery 10 can have higher efficiency.

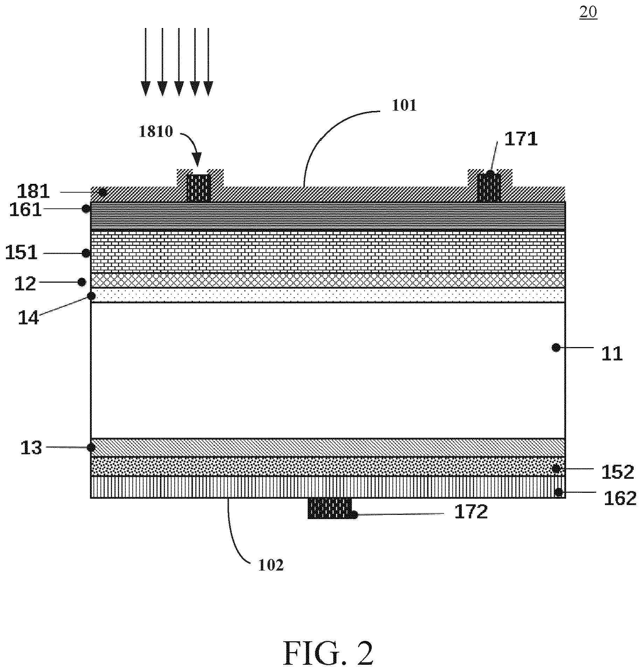

On the basis of the above embodiments, the present application may also have other modifications. For example, Fig. 2 shows a hybrid solar battery 20 according to another embodiment of the present application. Compared with Fig. 1, the details of the battery structure of the hybrid solar battery 20 are basically the same as those of the hybrid solar battery 10, so the same reference numerals are used for the same parts. Different from the embodiment shown in Fig. 1, in the embodiment shown in Fig. 2, a dielectric layer 181 is provided above the first conductive layer 161, that is, the outermost layer close to the first surface 101. At this time, the upper surface of the dielectric layer 181 also forms the first surface 101. The dielectric layer 181 can be made of transparent dielectric materials such as silicon nitride, silicon oxide, silicon oxynitride and so on. Exemplarily, in this embodiment, the thickness of the dielectric layer 181 at different positions is greater than or equal to 10 nanometers and less than or equal to 200 nanometers, preferably less than or equal to 100 nanometers. In this embodiment, the thickness of the first electrode 171 (the metal grid line) in the vertical direction in the arrangement shown in Fig. 2 is 5-50 microns, preferably 5-15 microns or 10-15 microns. When the first electrode 171 is implemented as a metal grid line, there are busbars and thin grid lines among the many grid lines on the surface of the battery; in actual production, laser (partial) grooves are especially required at the corresponding positions of the busbars, so that to form the opening 1810 as shown in Fig. 2, which is easy for subsequent soldering of ribbons and contact with metal grid lines. At the same time, the width of the grooves needs to be controlled so that the opening 1810 covers part or the entire welding point on the metal grid line (that is, the first electrode 171); in some cases, when the corresponding metal grid line has a welding point, the width of the opening of 1810 needs to be greater than the width of the welding point on the metal grid.

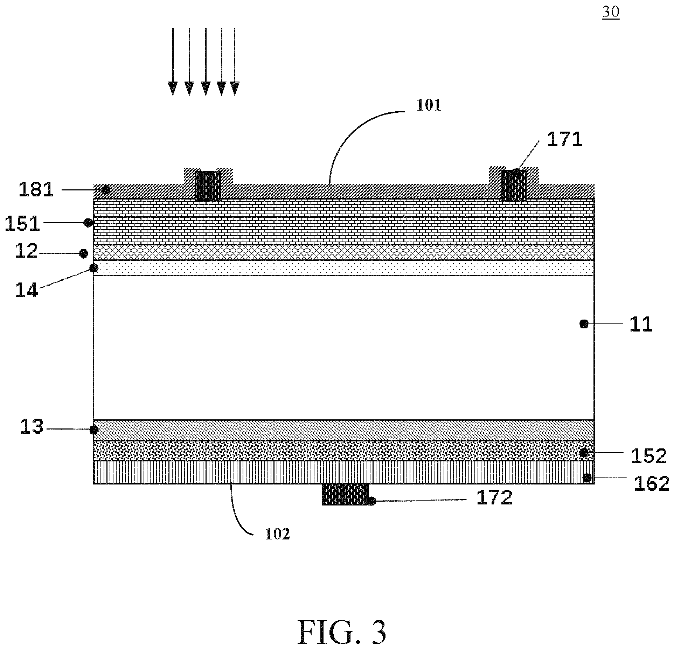

On this basis, Fig. 3 shows another modification of the embodiment shown in Fig. 2. As mentioned above, in some embodiments of the present application, the dielectric layer may be directly used to replace the first conductive layer. Fig. 3 shows such an embodiment. According to Fig. 3, for the hybrid solar battery 30, the dielectric layer 181 is located directly on the first doped layer 151 and is located close to the outermost layer of the first surface 101. For other details about the dielectric layer 181 will not be repeated here, and reference may be made to the description above.

Referring to the structures of hybrid solar batteries 10-30 shown in Fig. 1-Fig. 3 above, the TOPCon structure with a tunneling layer is placed on the light-facing surface of the battery. Due to the polycrystalline structure of TOPCon and the doping of elements such as oxygen and carbon, the battery can significantly reduce the optical parasitic absorption through the passivation contact, thereby increasing the light absorption of the battery substrate and improving the overall spectral response of the battery. From a process point of view, since the heterojunction passivation electrode structure is placed on the backlight side of the battery, the battery has low requirements on the surface morphology of the silicon substrate, which can simplify the related texturing and cleaning steps and reducing operating costs. Therefore, the above-mentioned structure of placing TOPCon on the light-facing side of the battery and placing the heterojunction passivation electrode structure on the backlight side has significant advantages over the prior art.

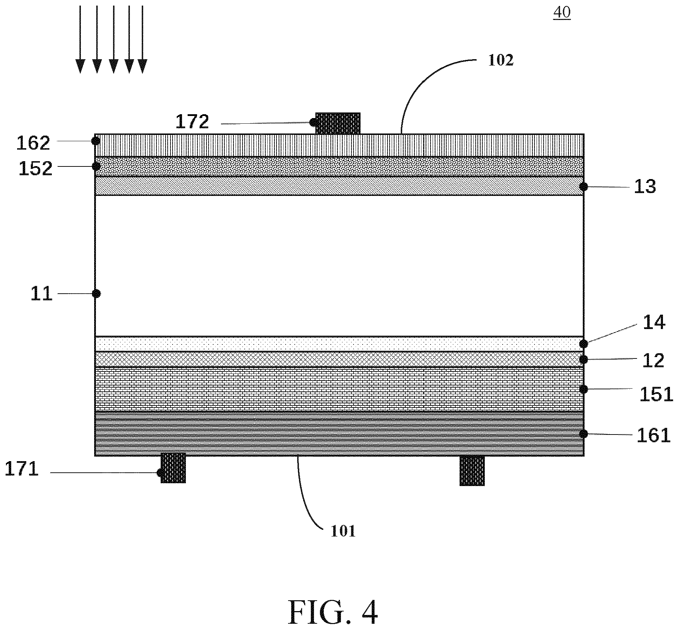

In addition, Fig. 4 shows another hybrid solar battery 40 of the present application. Different from the above-mentioned hybrid solar batteries 10, 20 and 30, the first surface 101 of the hybrid solar battery 40 is backlight surface, and the second surface 102 is a light-facing surface. It should be noted that, in this embodiment, the hybrid solar battery 40 has a first doped layer 151 located between the tunneling layer 12 and the first surface 101, and the thickness of the first doped layer 151 is 20-600 nanometers, and more preferably, the thickness of the first doped layer 151 can be designed within the range of 3-30 nanometers.

In this embodiment, similarly, the thickness of the tunneling layer 12 is not greater than 3 nanometers, and the tunneling layer 12 is silicon oxide, silicon oxynitride or aluminum oxide. The intrinsic amorphous silicon layer 13 contains at least one element among oxygen, carbon and nitrogen, and the thickness of the intrinsic amorphous silicon layer 13 is 3-15 nanometers. In addition, similar to the embodiment shown in Fig. 2 and Fig. 3, a dielectric (anti-reflection) layer similar to what has been described above may also be provided on the second conductive layer 162, or the second conductive layer 162 may be directly replaced with dielectric (anti-reflection) layer. For other details about the structure, size and material of each film layer of the hybrid solar battery 40, reference may be made to the previous descriptions with reference to Fig. 1 to Fig. 3, and the same interpretation will not be repeated here.

On the basis of the above description with reference to Fig. 1 to Fig. 4, another aspect of the present application also proposes a photovoltaic module, which is composed of hybrid solar batteries provided by any embodiment of the present application connected in series and/or in parallel.

The basic concepts have been described above, obviously, for those skilled in the art, the above disclosure of the invention is only an example, and does not constitute a limitation to the present application. Although not expressly stated here, various modifications, improvements and amendments to this application may be made by those skilled in the art. Such modifications, improvements, and amendments are suggested in this application, so such modifications, improvements, and amendments still belong to the spirit and scope of the exemplary embodiments of this application.

Meanwhile, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that two or more references to "one embodiment" or "an embodiment" or "an alternative embodiment" in different places in this specification do not necessarily refer to the same embodiment. In addition, certain features, structures or characteristics of one or more embodiments of the present application may be properly combined.

In the same way, it should be noted that in order to simplify the expression disclosed in the present application and help the understanding of one or more embodiments of the invention, in the foregoing description of the embodiments of the present application, sometimes multiple features are combined into one embodiment, drawings or descriptions thereof. However, this method of disclosure does not imply that the subject matter of the application requires more features than are recited in the claims. Indeed, embodiment features are less than all features of a single foregoing disclosed embodiment.

In some embodiments, numbers describing the quantity of components and attributes are used, it should be understood that such numbers used in the description of the embodiments use the modifiers "about", "approximately" or "substantially" in some examples. Unless otherwise stated, "about", "approximately" or "substantially" indicates that the stated figure allows for a variation of ±20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present application to confirm the breadth of the scope are approximate values, in specific embodiments, such numerical values are set as precisely as practicable.

Although the present application has been described with reference to the current specific embodiments, those of ordinary skill in the art should recognize that the above embodiments are only used to illustrate the present application, and various equivalent changes or substitutions can also be made without departing from the spirit of the present application, therefore, as long as the changes and modifications to the above-mentioned embodiments are within the spirit of the present application, they will all fall within the scope of the claims of the present application.

## Claims

1. A hybrid solar battery comprising a first surface and a second surface opposing to each other, **characterized in that**, the hybrid solar battery comprises:
a silicon substrate;
a tunneling layer located between the silicon substrate and the first surface; and
an intrinsic amorphous silicon layer located between the silicon substrate and the second surface.

2. The hybrid solar battery in claim 1, **characterized in that**, the first surface is a light-facing surface of the hybrid solar battery, and the second surface is a backlight surface of the hybrid solar battery.

3. The hybrid solar battery in claim 2, **characterized in that**, a thickness of the tunneling layer is not more than 3 nanometers, and the tunneling layer is composed of silicon oxide, silicon oxynitride or aluminum oxide.

4. The hybrid solar battery in claim 2 or 3, **characterized in that**, the hybrid solar battery further comprises a first doped layer located between the tunneling layer and the first surface, and a thickness of the first doped layer ranges from 10 to 600 nanometers.

5. The hybrid solar battery in claim 4, **characterized in that**, the first doped layer comprises a doped polysilicon, and the doped polysilicon contains at least one element among oxygen, carbon, and nitrogen.

6. The hybrid solar battery in claim 4, **characterized in that**, the hybrid solar battery further comprises a diffusion surface region located on the silicon substrate, the diffusion surface region is below the tunneling layer, wherein a doping type of the diffusion surface region is the same as the first doped layer, and a doping concentration of the diffusion surface region is less than the first doped layer.

7. The hybrid solar battery in claim 5, **characterized in that**, the hybrid solar battery further comprises a first conductive layer located between the first doped layer and the first surface, wherein a thickness of the first conductive layer ranges from 10 to 200 nanometers.

8. The hybrid solar battery in claim 5 or 7, **characterized in that**, the hybrid solar battery further comprises a dielectric layer located on an outermost layer close to the first surface.

9. The hybrid solar battery in claim 8, **characterized in that**, the dielectric layer is composed of silicon nitride, silicon oxide or silicon oxynitride, and a thickness of the dielectric layer ranges from 10 to 200 nanometers.

10. The hybrid solar battery in claim 8, **characterized in that**, the hybrid solar battery further comprises a first electrode and a negative electrode which are positioned on the first surface and the second surface respectively, wherein the dielectric layer locates on and /or above the first electrode, and the dielectric layer comprises an opening at a position where the first electrode locates for purpose of soldering.

11. The hybrid solar battery in claim 2, **characterized in that**, the intrinsic amorphous silicon layer contains at least one element among oxygen, carbon and nitrogen, and a thickness of the intrinsic amorphous silicon layer ranges from 3-15 nanometers.

12. The hybrid solar battery in claim 2 or 11, **characterized in that**, the hybrid solar battery further comprises a second doped layer located between the intrinsic amorphous silicon layer and the second surface, wherein a thickness of the second doped layer ranges from 3 to 60 nanometers.

13. The hybrid solar battery in claim 12, **characterized in that**, the second doped layer contains doped amorphous silicon or microcrystalline silicon film, and the second doped layer contains at least one element among oxygen, carbon, and nitrogen, wherein a doping type of the second doped layer is opposite to the silicon substrate.

14. The hybrid solar battery in claim 13, **characterized in that**, the doping type of the silicon substrate is N-type doping.

15. The hybrid solar battery in claim 12, **characterized in that**, the hybrid solar battery further comprises a second conductive layer, located between the second doped layer and the second surface, wherein a thickness of the second conductive layer ranges from 10-200 nanometers.

16. The hybrid solar battery in claim 7 or 15, **characterized in that**, the first conductive layer and/or the second conductive layer is transparent.

17. The hybrid solar battery in claim 1, **characterized in that**, the first surface is a backlight surface of the hybrid solar battery, and the second surface is a light-facing surface of the hybrid solar battery, wherein the hybrid solar battery further comprises a first doped layer located between the tunneling layer and the first surface, a thickness of the first doped layer is 10-600 nanometers.

18. The hybrid solar battery in claim 17, **characterized in that**, a thickness of the tunneling layer is not more than 3 nanometers, and the tunneling layer is composed of silicon oxide, silicon oxynitride or aluminum oxide.

19. The hybrid solar battery in claim 17 or 18, **characterized in that**, the intrinsic amorphous silicon layer contains at least one element among oxygen, carbon and nitrogen, and a thickness of the intrinsic amorphous silicon layer is 3-15 nanometers.

20. A photovoltaic module, comprising a plurality of hybrid solar batteries according to any one of claims 1-19 connected in series and/or in parallel.
